# EUROPEAN PATENT APPLICATION

(11) **EP 4 618 330 A1**
(43) Date of publication of application: **17.09.2025**
(21) Application number: 24206635.5
(22) Date of filing: 15.10.2024
(51) Int. Cl.: H02B 1/46, H02B 1/56, H05K 7/20, H01H 50/02

(54) **HIGH-VOLTAGE CONTROL BOX AND ENERGY STORAGE SYSTEM**

(30) Priority: 16.03.2024 CN 202420514040 U
(71) Applicant: Eve Energy Storage Co., Ltd., Wuhan, Hubei 430000 (CN)
(72) Inventor: HUANG, Mingxiang, Wuhan, Hubei, 430000 (CN); SUN, Hui, Wuhan, Hubei, 430000 (CN)
(74) Representative: Herrero & Asociados, S.L.

(57) **Abstract**

A high-voltage control box includes: a box body (10), being arranged with a receiving cavity (110) and a first opening (120); a first bracket (20), received in the receiving cavity and configured for mounting a component group (60); a cooling member (30), disposed in the first opening; and a heat conducting assembly (40), attached to and disposed between the cooling member and the first bracket.

## Description

### TECHNICAL FIELD

The present disclosure relates to the field of energy storage, and in particular to a high-voltage control box and an energy storage system.

### BACKGROUND

A high-voltage control box, also known as high-voltage case, is an important component of high-voltage power circuit management in an energy storage system. The high-voltage control box is an intermediate component connecting a battery cluster to an energy storage converter. The high-voltage control box is configured to collect a battery cluster voltage and a battery cluster current and configured to control and protect a battery cluster circuit contactor.

As requirements for operating conditions (charging-discharging rates, ambient temperatures, operating temperatures, and so on) of batteries increase, temperature rise of components in the high-voltage control box is also increasing. Therefore, a temperature inside the high-voltage control box is also increased. If heat inside the high-voltage control box cannot be conducted out of the box in time, temperatures of an internal environment and the components inside the high-voltage control box may further increase. When the temperature rise of the high-voltage control box is excessively high, the service life of the components may be affected, systemic failure and safety risk may be caused.

### SUMMARY

In the art, heat of the high-voltage control box may be dissipated naturally or by cool air. However, a heat dissipation effect is poor. The temperature rise inside the box is still high, easily resulting in the high-voltage control box being overheated, affecting the service life of components in the high-voltage control box.

In a first aspect, a high-voltage control box is provided, including: a box body, being arranged with a receiving cavity and a first opening; a first bracket, received in the receiving cavity and configured for mounting a component group; a cooling member, disposed in the first opening; and a heat conducting assembly, attached to and disposed between the cooling member and the first bracket.

In a second aspect, an energy storage system is provided, including a battery cluster and the high-voltage control box of the first aspect. The battery cluster is connected to the high-voltage control box.

According to some embodiments, the high-voltage control box includes a box body, a first bracket, a cooling member and a heat conducting assembly. The box body is arranged with a receiving cavity and a first opening. The first bracket is received in the receiving cavity. The first bracket is configured to mount a component group. The cooling member is arranged at the first opening. The heat conducting assembly is attached to and disposed between the first bracket and the cooling member to increase an efficiency of dissipating heat from the component group in the high-voltage control box. In the embodiments, the first bracket is arranged in the box, and the component group is mounted by the first bracket. In this way, the component group is mounted and fixed. Since the heat conducting assembly is disposed between the first bracket and the cooling member, heat generated by the component group is conducted to the cooling member through the heat conducting assembly. Therefore, the component group on the first bracket is cooled, and heat of the component group is dissipated, such that the heat dissipation effect in the high-voltage control box is improved, the temperature rise inside the high-voltage control box is effectively reduced. Operating conditions inside the box are stable, the service life of the components are extended, and systemic failures are reduced.

### BRIEF DESCRIPTION OF THE DRAWINGS

FIG. 1 is an exploded view of a high-voltage control box from a first viewing angle according to some embodiments.
FIG. 2 is an exploded view of the high-voltage control box from a second viewing angle according to some embodiments.
FIG. 3 a structural schematic view of a portion of the high-voltage control box according to some embodiments.
FIG. 4 is an exploded view of a portion of the high-voltage control box from the first viewing angle according to some embodiments.
FIG. 5 is an exploded view of a portion of the high-voltage control box from the second viewing angle according to some embodiments.
FIG. 6 is a cross-sectional view of the high-voltage control box according to some embodiments.
FIG. 7 is an enlarged view of a portion A shown in FIG. 6.

### Reference numerals in drawings:

10, box body; 110, receiving cavity; 120, first opening; 20, first bracket; 30, cooling member; 310, channel group; 320, inlet port; 330, outlet port; 40, heat conducting assembly; 410, heat conducting plate; 420, second heat dissipation member; 60, component group; 610, relay group; 612, pre-charge relay; 614, positive-electrode relay; 616, negative-electrode relay; 620, fuse group; 622, positive-electrode fuse; 624, negative-electrode fuse; 630, shunt; 640, pre-charge resistor; 650, electronic connection member; 70, mounting cavity group; 710, first mounting cavity; 712, first mounting sub-cavity; 714, second mounting sub-cavity; 716, third mounting sub-cavity; 720, second mounting cavity; 722, fourth mounting sub-cavity; 724, fifth mounting sub-cavity; 730, third mounting cavity; 740, fourth mounting cavity; 750, fifth mounting cavity; 810, first through hole; 820, second through hole; 830, third through hole; 840, fourth through hole; 850, fifth through hole; 860, fourth opening; 870, fifth opening; and 880, sixth opening.

### DETAILED DESCRIPTION

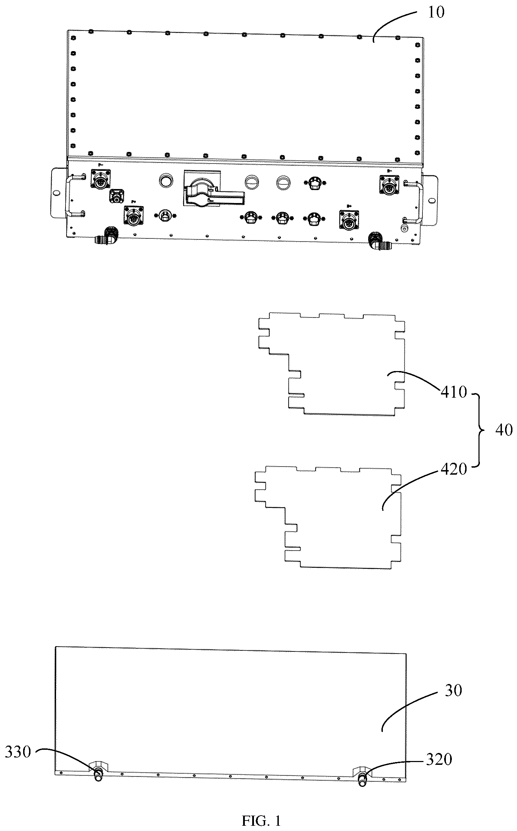

In an embodiment, as shown in FIGS. 1 to 4, a high-voltage control box is provided and includes a box body 10, a first bracket 20, a cooling member 30, and a heat conducting assembly 40. The box body 10 is arranged with a receiving cavity 110 and a first opening 120. The first bracket 20 is received in the receiving cavity 110. The first bracket 20 is configured for mounting a component group 60. The cooling member 30 is disposed in the first opening 120. The heat conducting component 40 is attached to and disposed between the cooling member 30 and the first bracket 20.

The box body 10 may be made of metal. The box body 10 may be, but is not limited to, square. For example, the box body 10 may be rectangular. The box body 10 may include a top cover plate and a side plate assembly. The side plate assembly includes a front plate, a rear plate, a left plate, and a right plate. The front plate, the rear plate, the left plate, and the right plate enclose to form the receiving cavity 110. The top cover plate is disposed on the side plate assembly. Exemplarily, the top cover plate and the side plate assembly may be connected to each other by screwing. The front plate, the rear plate, the left plate, and the right plate may be connected to each other by welding or screwing. Exemplarily, the front plate is arranged with a switch module, a power line interface group, and a communication interface group.

The first opening 120 is located below the side plate assembly. The first opening 120 is communicated to the receiving cavity 110. The cooling member 30 covers the first opening 120 such that the receiving cavity 110 is sealed. For example, the cooling member 30 may be arranged to a lower side of the side plate assembly by screwing or the like. The first bracket 20 is received in the receiving cavity 110, and the first bracket 20 is configured to mount and secure the component group 60. Exemplarily, the first bracket 20 may be fixed to the cooling member 30 by a bolt. In an example, the component group 60 includes a plurality of components, temperatures of which may be increased easily. The component group 60 may be arranged on the first bracket 20 by snapping. In order to enhance firmness of the mounting of the component group 60, the component group 60 may be secured to the first bracket 20 by bolts.

The heat conducting assembly 40 is configured to conduct heat generated by the component group 60 on the first bracket 20 to the cooling member 30. Exemplarily, a first side of the heat conducting assembly 40 is attached to the first bracket 20, and the component group 60 on the first bracket 20 may be directly or indirectly attached to the first side of the heat conducting assembly 40. For example, since different components have different sizes, a thermally conductive filler may be disposed between the heat conducting assembly 40 and the component group 60, such that the component group 60 can be directly or indirectly tightly attached to the first side of the heat conducting assembly 40. A second side of the heat conducting assembly 40 is attached to the cooling member 30, such that the heat generated by the component group 60 on the first bracket 20 is conducted to the cooling member 30 through the heat conducting assembly 40. Therefore, cooling and heat dissipation of the component group 60 is achieved.

The cooling member 30 may be a cool-liquid plate. The cooling member 30 is fluidly connected to a liquid cooling module. The liquid cooling module transmits a cooling liquid to the cooling member 30. The liquid cooling module is further configured to recycle the cooling liquid from the cooling member 30 after the cooling liquid is used. Further, the liquid cooling module cools the cooling liquid again and transmits the cooled cooling liquid to the cooling member 30, such that coldness is constantly transferred to the cooling member 30.

In the present embodiment, the box body 10 is arranged with the receiving cavity 110 and the first opening 120. The first bracket 20 is arranged in the receiving cavity 110. The first bracket 20 is used for mounting the component group 60. The heat conducting assembly 40 is attached to and disposed between the first bracket 20 and the cooling member 30 to increase an efficiency of dissipating heat from the component group 60 in the high-voltage control box. In some embodiments, the first bracket 20 is arranged in the box body 10, and the component group 60 is mounted by the first bracket 20. In this way, the component group 60 is mounted and fixed. Since the heat conducting assembly 40 is disposed between the first bracket 20 and the cooling member 30, heat generated by the component group 60 is conducted to the cooling member 30 through the heat conducting assembly 40. Therefore, the component group 60 on the first bracket 20 is cooled, and heat of the component group 60 is dissipated, such that the heat dissipation effect in the high-voltage control box is improved, the temperature rise inside the high-voltage control box is effectively reduced. Operating conditions inside the box are stable, the service life of the components are extended, and systemic failures are reduced.

In an embodiment, the high-voltage control box further includes a first heat dissipation member (not shown in the drawings). The first heat dissipation member is disposed between the first bracket 20 and the heat conducting assembly 40.

The first heat dissipation member may be, but is not limited to, a thermally conductive gel. For example, by filling the thermally conductive gel between the first bracket 20 and the heat conducting assembly 40, the thermally conductive gel fully fills a space between the heat conducting assembly 40 and the component group 60. In this way, the thermally conductive gel is tightly attached between the heat conducting assembly 40 and the component group 60. The heat generated by the component group 60 on the first bracket 20 can be transferred to the cooling member 30 by conducting through the thermally conductive gel and the heat conducting assembly 40 sequentially, such that heat of the component group 60 may be dissipated optimally.

In an embodiment, the first bracket 20 is arranged with a mounting cavity group 70. The component group 60 is received in the mounting cavity group 70. The mounting cavity group 70 has an opening group. A first heat dissipation member is filled in the opening group. The first heat dissipation member is attached between the component group 60 and the heat conducting assembly 40.

The mounting cavity group 70 includes a plurality of mounting cavities. The number of the plurality of mounting cavities is determined by the number of components included in the component group 60. The mounting cavity group 70 is a hollow cavity group and has the opening group. The opening group is located adjacent to the heat conducting assembly 40. Exemplarily, the component group 60 may be entirely or partially embedded in the mounting cavity group 70. In another example, the component group 60 may be disposed adjacent to a top of the mounting cavity group 70.

For example, by filling the opening group with the first heat dissipation member, the first heat dissipation member fully fills the mounting cavity group 70 until the opening group is fully filled by the first heat dissipation member. In this way, a first side of the first heat dissipation member is attached to the component group 60, and a second side of the first heat dissipation member is attached to the heat conducting assembly 40. The heat generated by the component group 60 can be transferred to the cooling member 30 by being conducted through the first heat dissipation member and the heat conducting assembly 40 sequentially, such that the cooling member 30 is cooled. In addition, the component group 60 is received in the mounting cavity group 70, therefore, the component group 60 is mounted and fixed, and the components of the component group 60 are thermally insulated from each other.

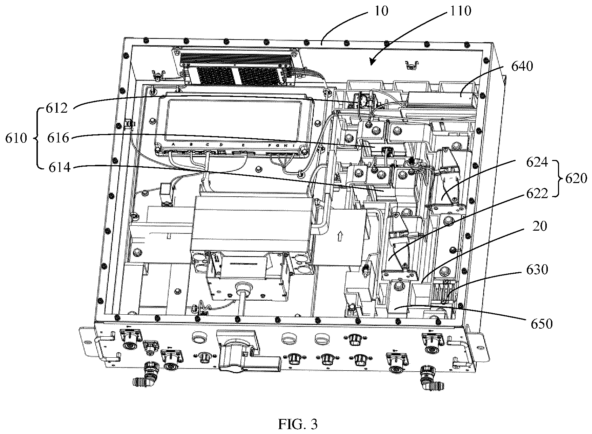

In an embodiment, as shown in FIG. 3, the component group 60 includes a relay group 610 and a fuse group 620. The mounting cavity group 70 includes a first mounting cavity 710 and a second mounting cavity 720. The relay group 610 is received in the first mounting cavity 710, and the fuse group 620 is received in the second mounting cavity 720. The first mounting cavity 710 has a second opening, the second mounting cavity 720 has a third opening. The second opening and the third opening are respectively filled by the first heat dissipation member. The first side of the first heat dissipation member is attached to the relay group 610 and the fuse group 620, and the second side of the first heat dissipation member is attached to the heat conducting assembly 40.

The relay group 610 includes a plurality of relays, and the fuse group 620 includes a plurality of fuses. A plurality of first mounting positions are arranged in the first mounting cavity 710. Each of the plurality of relays is arranged on a respective one of the plurality of first mounting positions. A plurality of second mounting positions are arranged in the second mounting cavity 720. Each of the plurality of fuses is arranged on a respective one of the plurality of second mounting positions.

By filling the second opening with the first heat dissipation member, the first heat dissipation member is filled in the first mounting cavity 710 until the second opening is fully filled with the first heat dissipation member. In this way, the first side of the first heat dissipation member is attached to the relay group 610, and the second side of the first heat dissipation member is attached to the heat conducting assembly 40. Therefore, heat generated by the relay group 610 can be transferred to the cooling member 30 by being conducted through the first heat dissipation member and the heat conducting assembly 40 sequentially, such that the relay group 610 is cooled. By filling the third opening with the first heat dissipation member, the first heat dissipation member fully fills the second mounting cavity 720 until the third opening is fully filled by the first heat dissipation member. In this way, the first side of the first heat dissipation member is attached to the fuse group 620, and the second side of the first heat dissipation member is attached to the heat conducting assembly 40. Therefore, heat generated by the fuse group 620 can be transferred to the cooling member by being conducted through the first heat dissipation member and the heat conducting assembly 40 sequentially, such that the fuse group 610 is cooled. In addition, since the relay group 610 is received in the first mounting cavity 710 and the fuse group 620 is received in the second mounting cavity 720, the relay group 610 and the fuse group 620 are mounted and fixed, and the relay group 610 and the fuse group 620 are thermally insulated form each other.

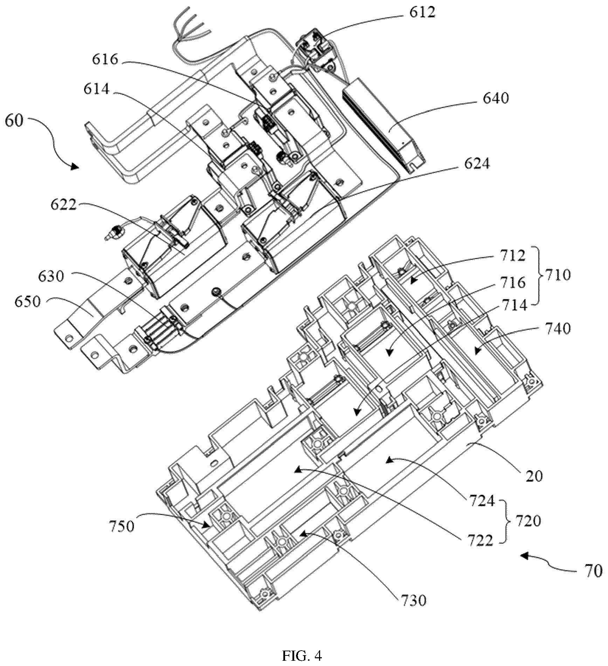

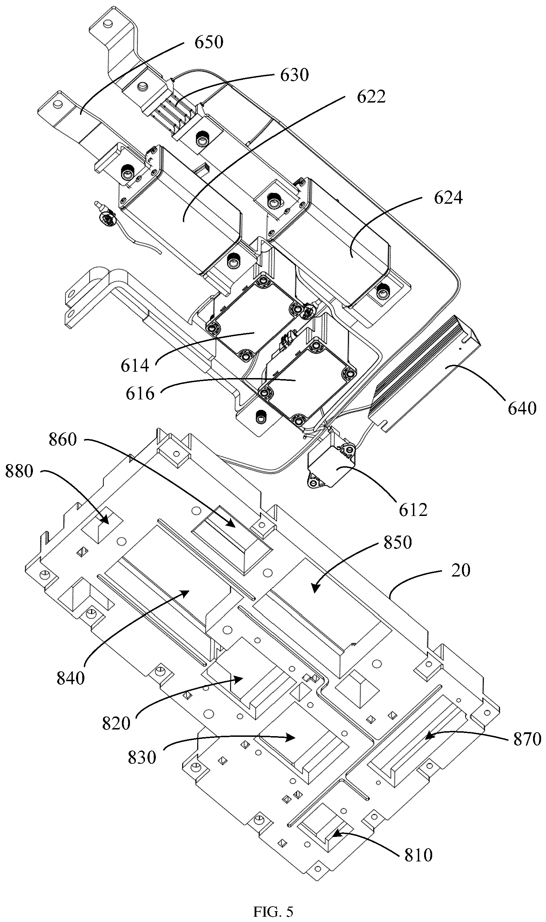

In an example, as shown in FIGS. 4 and 5, the relay group 610 includes a pre-charge relay 612, a positive-electrode relay 614, and a negative-electrode relay 616. The fuse group 620 includes a positive-electrode fuse 622 and a negative-electrode fuse 624. The first mounting cavity 710 includes a first mounting sub-cavity 712, a second mounting sub-cavity 714, and a third mounting sub-cavity 716. The second mounting cavity 720 includes a fourth mounting sub-cavity 722 and a fifth mounting sub-cavity 724. The pre-charge relay 612 is received in the first mounting sub-cavity 712. The positive-electrode relay 614 is received in the second mounting sub-cavity 714. The negative-electrode relay 616 is received in the third mounting sub-cavity 716. The positive-electrode fuse 622 is received in the fourth mounting sub-cavity 740, and the negative-electrode fuse 624 is received in the fifth mounting sub-cavity 724. The first mounting sub-cavity 712 has a first through hole 810, the second mounting sub-cavity 714 has a second through hole 820, the third mounting sub-cavity 716 has a third through-hole 830, the fourth mounting sub-cavity 722 has a fourth through hole 840, and the fifth mounting sub-cavity 724 has a fifth through hole 850. The first heat dissipation member is filled, through the first through hole 810, to the first mounting sub-cavity 712 to enable the first heat dissipation member to be attached between the pre-charged relay 612 and the heat conducting assembly 40. The first heat dissipation member is filled, through the second through hole 820, to the second mounting sub-cavity 714 to enable the first heat dissipation member to be attached between the positive-electrode relay 614 and the heat conducting assembly 40. The first heat dissipation member is filled, through the third through hole 830, to the third mounting sub-cavity 716 to enable the first heat dissipation member to be attached between the negative-electrode relay 616 and the heat conducting assembly 40. The first heat dissipation member is filled, through the fourth through hole 840, to the fourth mounting sub-cavity 722 to enable the first heat dissipation member to be attached between the positive-electrode fuse 622 and the heat conducting assembly 40. The first heat dissipation member is filled, through the fifth through hole 850, to the fifth mounting sub-cavity 724 to enable the first heat dissipation member to be attached between the negative-electrode fuse 624 and the heat conducting assembly 40.

The pre-charge relay 612 refers to an equalization relay. The positive-electrode relay 614 refers to a positive-electrode circuit relay. The negative-electrode relay 616 refers to a negative-electrode circuit relay. The positive-electrode fuse 622 refers to a positive-electrode circuit fuse, and the negative-electrode fuse 624 refers to a negative-electrode circuit fuse.

The first mounting sub-cavity 712 is a hollow cavity and is used to receive the pre-charge relay 612. For example, a bottom of the pre-charge relay 612 is embedded in the first mounting sub-cavity 712, such that the pre-charge relay 612 is limited and fixed. The second mounting sub-cavity 714 is a hollow cavity and is used to receive the positive-electrode relay 614. For example, a bottom of the positive-electrode relay 614 is embedded in the second mounting sub-cavity 714, such that the positive-electrode relay 61 is limited and fixed. The third mounting sub-cavity 716 is a hollow cavity and is used to receive the negative-electrode relay 616. For example, a bottom of the negative-electrode relay 616 is embedded in the third mounting sub-cavity 716, such that the negative-electrode relay 616 is limited and fixed. The fourth mounting sub-cavity 722 is a hollow cavity and is used to receive the positive-electrode fuse 622. For example, a bottom of the positive-electrode fuse 622 is embedded in the fourth mounting sub-cavity 722, such that the positive-electrode fuse 622 is limited and fixed. The fifth mounting sub-cavity 724 is a hollow cavity and is used to receive the negative-electrode fuse 624. For example, a bottom of the negative-electrode fuse 624is embedded in the fifth mounting sub-cavity 724, such that the negative-electrode fuse 624 is limited and fixed. Exemplarily, the first mounting sub-cavity 712, the second mounting sub-cavity 714, the third mounting sub-cavity 716, the fourth mounting sub-cavity 722, and the fifth mounting sub-cavity 724 are provided spaced apart from each other.

The second opening is divided into a first through hole 810, a second through hole 820, and a third through hole 830. The first through hole 810 is communicated with the first mounting sub-cavity 712, the second through hole 820 is communicated with the second mounting sub-cavity 714, and the third through hole 830 is communicated with the third mounting sub-cavity 716. By filling the first through hole 810 with the first heat dissipation member, the first heat dissipation member fully fills the first mounting sub-cavity 712 until the first through hole 810 is fully filled by the first heat dissipation member. In this way, the first side of the first heat dissipation member is attached to the pre-charged relay 612, and the second side of the first heat dissipation member is attached to the heat conducting assembly 40. The heat generated by the pre-charged relay 612 is conducted to the cooling member 30 being conducted through the first heat dissipation member and the heat conducting assembly 40 sequentially, such that the pre-charged relay 612 is cooled. By filling the second through hole 820 with the first heat dissipation member, the first heat dissipation member fully fills the second mounting sub-cavity 714 until the second through hole 820 is fully filled by the first heat dissipation member. In this way, the first side of the first heat dissipation member is attached to the positive-electrode relay 614, and the second side of the first heat dissipation member is attached to the heat conducting assembly 40. The heat generated by the positive-electrode relay 614 is transmitted to the cooling member 30 by being conducted through the first heat dissipation member and the heat conducting assembly 40 sequentially. Therefore, the positive-electrode relay 614 is cooled. By filling the third through hole 830 with the first heat dissipation member, the first heat dissipation member fully fills the third mounting sub-cavity 716 until the third through hole 830 is fully filled by the first heat dissipation member. In this way, the first side of the first heat dissipation member is attached to the negative-electrode relay 616, and the second side of the first heat dissipation member is attached to the heat conducting assembly 40. The heat generated by the negative-electrode relay 616 is transferred to the cooling member 30 by being conducted through the first heat dissipation member and the heat conducting assembly 40 sequentially. Therefore, the negative-electrode relay 616 is cooled.

The third opening is divided into a fourth through hole 840 and a fifth through hole 850. The fourth through hole 840 is communicated with the fourth mounting sub-cavity 722, and the fifth through hole 850 is communicated with the fifth mounting sub-cavity 724. By filling the fourth through hole 840 with the first heat dissipation member, the first heat dissipation member fully fills the fourth mounting sub-cavity 722 until the fourth through hole 840 is fully filled by the first heat dissipation member. In this way, the first side of the first heat dissipation member is attached to the positive-electrode fuse 622, and the second side of the first heat dissipation member is attached to the heat conducting assembly 40. The heat generated by the positive-electrode fuse 622 is transferred to the cooling member 30 by being conducted through the first heat dissipation member and the heat conducting assembly 40 sequentially. Therefore, the positive-electrode fuse 622 is cooled. The heat dissipation effect of the high-voltage control box is improved, the temperature rise inside the high-voltage control box is reduced effectively, the operating conditions in the box are stabilized, the service life of each relay and each fuse is extended, and the systemic failures are reduced.

In an embodiment, as shown in FIGS. 4 and 5, the component group 60 further includes a shunt 630 and a pre-charge resistor 640. The mounting cavity group 70 further includes a third mounting cavity 730 and a fourth mounting cavity 740. The shunt 630 is received in the third mounting cavity 730, and the pre-charge resistor 640 is received in the fourth mounting cavity 740. The third mounting cavity 730 has a fourth opening 860, the fourth mounting cavity 740 has a fifth opening 870. The fourth opening 860 and the fifth opening 870 are respectively filled by the first heat dissipation member. The first side of the first heat dissipation member is attached to the shunt 630 and the pre-charge resistor 640, and the second side of the first heat dissipation member is attached to the heat conducting assembly 40.

The pre-charge resistor 640 refers to an equalization resistor. The third mounting cavity 730 is a hollow cavity and is used to receive the shunt 630. For example, a bottom of the shunt 630 is embedded in the third mounting cavity 730, such that the shunt 630 is limited and fixed. The fourth mounting cavity 740 is a hollow cavity and is used to receive the pre-charge resistor 640. For example, a bottom of the pre-charge resistor 640 is embedded in the fourth mounting cavity 740, such that the pre-charge resistor 640 is limited and fixed. Exemplarily, the third mounting cavity 730 and the fourth mounting cavity 740 are spaced apart from each other.

The fourth opening 860 is communicated with the third mounting cavity 730, and the fifth opening 870 is communicated with the fourth mounting cavity 740. By filling the fourth opening 860 with the first heat dissipation member, the first heat dissipation member fills the third mounting cavity 730 until the fourth opening 860 is fully filled by the first heat dissipation member. In this way, the first side of the first heat dissipation member is attached to the shunt 630, and the second side of the first heat dissipation member is attached to the heat conducting assembly 40. The heat generated by the shunt 630 is transferred to the cooling member 30 by being conducted through the first heat dissipation member and the heat conducting assembly 40 sequentially, such that the shunt 630 is cooled. By filling the fifth opening 870 with the first heat dissipation member, the first heat dissipation member fills the fourth mounting cavity 740 until the fifth opening 870 is fully filled by the first heat dissipation member. In this way, the first side of the first heat dissipation member is attached to the pre-charge resistor 640, and the second side of the first heat dissipation member is attached to the heat conducting assembly 40. The heat generated by the pre-charge resistor 640 is transferred to the cooling member 30 by being conducted through the first heat dissipation member and the heat conducting assembly 40 sequentially, such that the pre-charge resistor 640 is cooled. Temperature rise of the pre-charge resistor 640 and the shunt 630 is effectively reduced, the operating conditions in the box are stabilized, the service life of the pre-charge resistor 640 and the shunt 630 is extended, and systemic failures are reduced.

In an embodiment, as shown in FIGS. 4 and 5, the component group 60 further includes an electronic connection member 650. The mounting cavity group 70 further includes a fifth mounting cavity 750. The electronic connection member 650 is received in the fifth mounting cavity 750. The fifth mounting cavity 750 has a sixth opening 880, the sixth opening 880 is filled by the first heat dissipation member. The first side of the first heat dissipation member is attached to the electronic connection member 650, the second side of the first heat dissipation member is attached to the heat conducting assembly 40.

The electronic connection member 650 may be, but is not limited to, a copper plate. The fifth mounting cavity 750 is a hollow cavity, and the electronic connection member 650 is located above the fifth mounting cavity 750.

The sixth opening 880 is communicated with the fifth mounting cavity 750. By filling the first heat dissipation member to the sixth opening 880, the first heat dissipation member is filled in the fifth mounting cavity 750 until the sixth opening 880 is fully filled by the first heat dissipation member. In this way, the first side of the first heat dissipation member is attached to the electronic connection member 650, and the second side of the first heat dissipation member is attached to the heat conducting assembly 40. The heat generated by the electronic connection member 650 is transferred to the cooling member 30 by being conducted through the first heat dissipation member and the heat conducting assembly 40 sequentially, such that the electronic connection member 650 is cooled. Temperature rise of the electronic connection member 650 is effectively reduced, the operating conditions in the box are stabilized, the amount of heat transferred between the components connected to the electronic connection member 650 is reduced, and systemic failures are reduced.

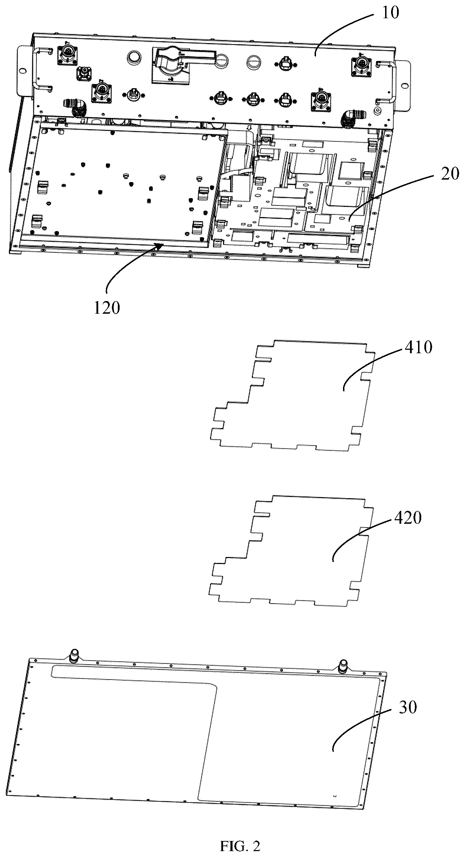

In an embodiment, as shown in FIGS. 1 and 2, the heat conducting assembly 40 includes a heat conducting plate 410 and a second heat dissipation member 420. The heat conducting plate 410 is attached to the first bracket 20. The second heat dissipation member 420 is attached between the cooling member 30 and the heat conducting plate 410.

The heat conducting plate 410 may be, but is not limited to, an aluminum plate, and the second heat dissipation member 420 may be, but is not limited to, a thermally conductive silicone pad.

By arranging the second heat dissipation member 420 to be attached between the cooling member 30 and the heat conducting plate 410, the second heat dissipation member 420 fully contacts the cooling member 30 and the heat conducting plate 410, such that the heat of the component group 60 can be transferred to the cooling member 30 by being conducted through the heat conducting plate 410 and the second heat dissipation member 420 sequentially, such that the component group 60 on the first bracket 20 is cooled. The heat dissipation effect inside the high-voltage control box is improved, the temperature rise inside the box is effectively reduced, the operating conditions inside the box are stabilized, the service life of the components is extended, and systemic failures are reduced.

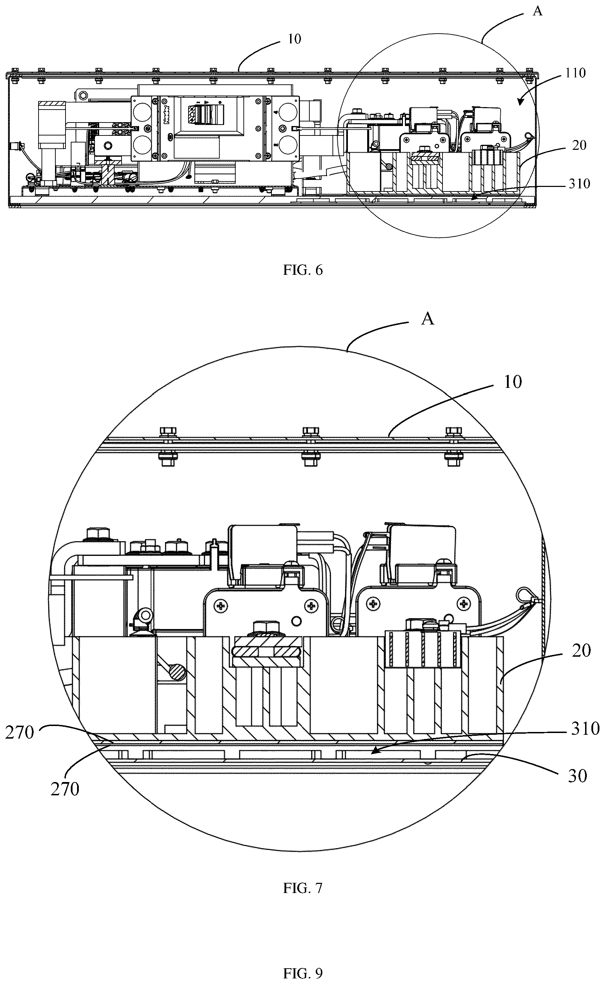

In an embodiment, as shown in FIGS. 1, 6, and 7, the cooling member 30 is arranged with a channel group 310, an inlet port 320, and an outlet port 330. The channel group 310 is communicated between the inlet port 320 and the outlet port 330.

The channel group 310 includes a plurality of first channels, and the plurality of first channel are communicated to each other and arranged in series and/or in parallel with each other.

Exemplarily, the inlet port 320 is communicated to an output end of the liquid cooling module. The outlet port 330 is communicated to an input end of the liquid cooling module. When the liquid cooling module is powered on and is operating, the liquid cooling module transmits the cool liquid to the cooling member 30. In this way, the cool liquid flows in the channel group 310, takes away the heat transferred from the component group 60, and flows back to the liquid cooling module. The liquid cooling module recycles and cools the cool liquid again and transfers the cool liquid to the cooling member 30 again, such that coldness is transferred to the cooling member 30 constantly.

Embodiments further provide an energy storage system including a battery cluster and the high-voltage control box. The battery cluster is connected to the high-voltage control box.

The battery cluster includes a plurality of battery packs that are connected to each other in series and/or in parallel. An end of the high-voltage control box is connected to the battery cluster, and the other end of the high-voltage control box is connected to an energy storage converter, such that the high-voltage control box can control charging/discharging of the battery cluster.

Detailed description of the high-voltage control box may be referred to the embodiments, and will not be repeated herein.

The high-voltage control box includes the case body, the first bracket, the cooling member, and the heat conducting assembly. The box body is arranged with the receiving cavity and the first opening. The first bracket is received in the receiving cavity, and the first bracket is used for mounting the component group 60. The cooling member is disposed in the first opening. The heat conducting assembly is attached to and disposed between the cooling member and the first bracket to improve the heat dissipation efficiency of the component group 60 in the high-voltage control box.

In some embodiments, the first bracket is arranged in the box, and the component group 60 is mounted by the first bracket. In this way, the component group 60 is mounted and fixed. Since the heat conducting assembly is disposed between the first bracket and the cooling member, heat generated by the component group 60 is conducted to the cooling member through the heat conducting assembly. Therefore, the component group 60 on the first bracket is cooled, and heat of the component group 60 is dissipated, such that the heat dissipation effect in the high-voltage control box is improved, the temperature rise inside the high-voltage control box is effectively reduced. Operating conditions inside the box are stable, the service life of the components are extended, and systemic failures are reduced.

To be noted that the high-voltage control box may further include components such as a battery cluster management unit. Specifically, the high-voltage control box may include more components than those described in the embodiments, or some components can be combined, or some components may be arranged at different locations.

## Claims

1. A high-voltage control box, **characterized by** comprising:
a box body (10), being arranged with a receiving cavity (110) and a first opening (120);
a first bracket (20), received in the receiving cavity (110) and configured for mounting a component group (60);
a cooling member (30), disposed in the first opening (120); and
a heat conducting assembly (40), attached to and disposed between the cooling member (30) and the first bracket (20).

2. The high-voltage control box according to claim 1, wherein, the first bracket (20) is arranged with a mounting cavity group (70), and the component group (60) is received in the mounting cavity group (70).

3. The high-voltage control box according to claim 2, further comprising a first heat dissipation member,
wherein, the first heat dissipation member is disposed between the first bracket (20) and the heat conducting assembly (40).

4. The high-voltage control box according to claim 3, wherein, the mounting cavity group (70) has an opening group, the first heat dissipation member is filled in the opening group, the first heat dissipation member is attached between the component group (60) and the heat conducting assembly (40).

5. The high-voltage control box according to claim 4, wherein, the component group (60) comprises a relay group (610) and a fuse group (620); the mounting cavity group (70) comprises a first mounting cavity (710) and a second mounting cavity (720); the relay group (610) is received in the first mounting cavity (710); and the fuse group (620) is received in the second mounting cavity (720); and
the first mounting cavity (710) has a second opening, the second mounting cavity (720) has a third opening; each of the second opening and the third opening is filled by the first heat dissipation member; a first side of the first heat dissipation member is attached to the relay group (610) and the fuse group (620), and a second side of the first heat dissipation member is attached to the heat conducting assembly (40).

6. The high-voltage control box according to claim 5, wherein,
the relay group (610) comprises a pre-charge relay (612), a positive-electrode relay (614), and a negative-electrode relay (616); the fuse group (620) comprises a positive-electrode fuse (622) and a negative-electrode fuse (624); the first mounting cavity (710) comprises a first mounting sub-cavity (712), a second mounting sub-cavity (714), and a third mounting sub-cavity (716); the second mounting cavity (720) comprises a fourth mounting sub-cavity (722) and a fifth mounting sub-cavity (724); the pre-charge relay (612) is received in the first mounting sub-cavity (712); the positive-electrode relay (614) is received in the second mounting sub-cavity (714); the negative-electrode relay (616) is received in the third mounting sub-cavity (716); the positive-electrode fuse (622) is received in the fourth mounting sub-cavity (722); and the negative-electrode fuse (624) is received in the fifth mounting sub-cavity (724);
the first mounting sub-cavity (712) has a first through hole (810), the second mounting sub-cavity (714) has a second through hole (820), the third mounting sub-cavity (716) has a third through-hole (830), the fourth mounting sub-cavity (722) has a fourth through hole (840), and the fifth mounting sub-cavity (724) has a fifth through hole (850);
the first heat dissipation member is filled, through the first through hole (810), to the first mounting sub-cavity (712) to enable the first heat dissipation member to be attached between the pre-charged relay and the heat conducting assembly (40); the first heat dissipation member is filled, through the second through hole (820), to the second mounting sub-cavity (714) to enable the first heat dissipation member to be attached between the positive-electrode relay (614) and the heat conducting assembly (40); the first heat dissipation member is filled, through the third through hole (830), to the third mounting sub-cavity (716) to enable the first heat dissipation member to be attached between the negative-electrode relay (616) and the heat conducting assembly (40);
the first heat dissipation member is filled, through the fourth through hole (840), to the fourth mounting sub-cavity (722) to enable the first heat dissipation member to be attached between the positive-electrode fuse (622) and the heat conducting assembly (40); the first heat dissipation member is filled, through the fifth through hole (850), to the fifth mounting sub-cavity (724) to enable the first heat dissipation member to be attached between the negative-electrode fuse (624) and the heat conducting assembly (40).

7. The high-voltage control box according to claim 5, wherein, the relay group (610) comprises a plurality of relays, a plurality of first mounting positions are arranged in the first mounting cavity (710), each of the plurality of relays is mounted on a respective one of the plurality of first mounting positions.

8. The high-voltage control box according to claim 5, wherein, the fuse group (620) comprises a plurality of fuses, a plurality of second mounting positions are arranged in the second mounting cavity, each of the plurality of fuses is mounted on a respective one of the plurality of second mounting positions.

9. The high-voltage control box according to claim 4, wherein, the component group (60) further comprises a shunt (630) and a pre-charge resistor (640);
the mounting cavity group (70) further comprises a third mounting cavity (730) and a fourth mounting cavity (740); the shunt (630) is received in the third mounting cavity (730), and the pre-charge resistor (640) is received in the fourth mounting cavity (740);
the third mounting cavity (730) has a fourth opening (860), the fourth mounting cavity (740) has a fifth opening (870), each of the fourth opening (860) and the fifth opening (870) is filled by the first heat dissipation member, the first side of the first heat dissipation member is attached to the shunt (630) and the pre-charge resistor (640), and the second side of the first heat dissipation member is attached to the heat conducting assembly (40).

10. The high-voltage control box according to claim 4, wherein, the component group (60) further comprises an electronic connection member (650);
the mounting cavity group (70) further comprises a fifth mounting cavity; the electronic connection member (650) is received in the fifth mounting cavity (750);
the fifth mounting cavity (750) has a sixth opening (880), the sixth opening (880) is filled by the first heat dissipation member; the first side of the first heat dissipation member is attached to the electronic connection member, the second side of the first heat dissipation member is attached to the heat conducting assembly (40).

11. The high-voltage control box according to any one of claims 1 to 10, wherein, the heat conducting assembly (40) comprises a heat conducting plate and a second heat dissipation member;
the heat conducting plate is attached to the first bracket (20); the second heat dissipation member is attached between the cooling member (30) and the heat conducting plate.

12. The high-voltage control box according to claim 1, wherein, the cooling member (30) is arranged with a channel group (310), an inlet port (320), and an outlet port (330); the channel group (310) is communicated between the inlet port (320) and the outlet port (330).

13. The high-voltage control box according to claim 12, further comprising a liquid cooling module configured to transfer cool liquid to the cooling member (30) and recycle the cool liquid flowing from the cooling member (30).

14. The high-voltage control box according to claim 13, wherein, the inlet port (320) is fluidly connected to an output end of the liquid cooling module, and the outlet port (330) is fluidly connected to an input end of the liquid cooling module.

15. An energy storage system, comprising a battery cluster and the high-voltage control box according to any one of claims 1 to 14; wherein, the battery cluster is connected to the high-voltage control box.
